(19) Europäisches Patentamt
European Patent Office
Office européen des brevets

(11) **EP 2 362 713 A2**

(12) **EUROPEAN PATENT APPLICATION**

(43) Date of publication:
**31.08.2011 Bulletin 2011/35**

(51) Int Cl.:
**H05B 33/10** *(2006.01)*    **H05B 33/14** *(2006.01)*

(21) Application number: **11154640.4**

(22) Date of filing: **16.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.02.2010 JP 2010034714**

(71) Applicant: **Kabushiki Kaisha Toshiba Tokyo (JP)**

(72) Inventors:
• **Koizumi, Hiroshi**
  **Tokyo (JP)**

• **Okada, Yasuhide**
  **Tokyo (JP)**
• **Yamabe, Jyunsei**
  **Tokyo (JP)**
• **Sakurai, Naoaki**
  **Tokyo (JP)**

(74) Representative: **HOFFMANN EITLE**
**Patent- und Rechtsanwälte**
**Arabellastraße 4**
**81925 München (DE)**

(54) **Light emitting device, method for manufacturing the same and apparatus for manufacturing light emitting device**

(57)    According to one embodiment, a light emitting device includes a package member, a light emitting element provided in the package member, a first phosphor layer and a second phosphor layer. A first phosphor layer is provided on the light emitting element and has a first phosphor. A second phosphor layer is provided on the first phosphor layer and has a second phosphor. A luminescent efficiency of the first phosphor is higher than a luminescent efficiency of the second phosphor.

FIG. 1A

EP 2 362 713 A2

**Description**

<u>Field</u>

Embodiments described herein generally to a light emitting device, a method for manufacturing the same and an apparatus for manufacturing the light emitting device.

<u>Background</u>

A light emitting element and a phosphor are used to obtain an incandescent light (white-light) in a light emitting device. The light emitting element (for instance, a light emitting diode) emits blue-light, and the phosphor emits light complementing blue-light. The light emitting device is prepared by putting a drop of a paste-like resin mixed with the phosphor on the light emitting element, after the light emitting element is mounted in an enclosure made with a resin (e.g., refer to JP-A 2009-147312 (Kokai)).

However, there are some problems described below. A variability of chromaticities increases in case that many different types of the phosphor are mixed into a single layer resin. Furthermore, there is a case that the drop of the paste-like resin, mixed with the phosphor, is put on the light emitting element and a position of the drop gets into misalignment from a central portion of the light emitting element. Therefore, a fabrication yield for manufacturing the light emitting device degrades.

<u>BRIEF DESCRIPTION OF THE DRAWINGS</u>

FIGS. 1A and 1B are schematic views of a principal part of a light emitting device according to an embodiment;
FIGS. 2A and 2B are views for describing compiling databases;
FIG. 3 is a flowchart diagram for describing a process for manufacturing the light emitting device;
FIGS. 4A to 6C are schematic views of a principal part for describing the process for manufacturing the light emitting device;
FIGS. 7A and 7B are schematic views of a principal part of the light emitting device according to an embodiment;
FIGS. 8A to 8H are schematic views of a principal part for describing a process for manufacturing the light emitting device;
FIGS. 9A to 9C are views for describing a relationship between wavelengths and chromaticities; and
FIG. 10 is a view of a principal part of an apparatus for manufacturing a light emitting device.

<u>DETAILED DESCRIPTION</u>

In general, according to one embodiment, a light emitting device includes a package member, a light emitting element provided in the package member, a first phosphor layer and a second phosphor layer. A first phosphor layer is provided on the light emitting element and has a first phosphor. A second phosphor layer is provided on the first phosphor layer and has a second phosphor. A luminescent efficiency of the first phosphor is higher than a luminescent efficiency of the second phosphor.

According to another embodiment, a method for manufacturing a light emitting device is disclosed. The light emitting device includes a package member, a light emitting element provided in the package member, a first phosphor layer provided on the light emitting element and having a first phosphor, a second phosphor layer provided on the first phosphor layer and having a second phosphor. The method includes determining previously a dependence property of chromaticities of a mixed light emitted from the light emitting element, the first phosphor, and the second phosphor on a wavelength and an intensity of a light emitted from the light emitting element, a first total weight of the first phosphor, or a second total weight of the second phosphor. The method includes measuring the wavelength and the intensity of the light emitted from the light emitting element. The method includes determining the first total weight and the second total weight individually based on the dependence property so as to obtain predetermined chromaticities of the mixed light including the measured wavelength and the measured intensity. The method includes covering at least a part of the light emitting element with the first phosphor layer containing the first phosphor of the first total weight. The method includes covering at least a part of the first phosphor layer with the second phosphor layer containing the second phosphor of the second total weight.

According to another embodiment, an apparatus for manufacturing a light emitting device is provided. The light emitting device includes a package member, a light emitting element provided in the package member, a first phosphor layer provided on the light emitting element and having a first phosphor, a second phosphor layer provided on the first phosphor layer and having a second phosphor. The apparatus includes a memorizing unit, a measuring unit, a determining unit, a first covering unit and a second covering unit. The memorizing unit is configured to store a dependence property of chromaticities of a mixed light emitted from the light emitting element, the first phosphor, and the second phosphor on a wavelength and an intensity of a light emitted from the light emitting element, a first total weight of the first phosphor, or a second total weight of the second phosphor. The measuring unit is configured to measure the wavelength and the intensity of the light emitted from the light emitting element. The determining unit is configured to determine the first total weight and the second total weight individually based on the dependence property so as to obtain predetermined chromaticities of the mixed light including the measured wavelength and the measured intensity. The first covering unit is configured to cover at least a part of the light emitting element with a first phosphor layer containing the first phosphor of the first total weight. The second covering unit is configured to cover at least a part of the first phosphor layer with a second phosphor layer containing the second phosphor of the second total weight.

Embodiments will now be described with reference to the drawings. Components of the below-described first to third embodiments can be combined properly. Each of components in the embodiments is not independent.

(First Embodiment)

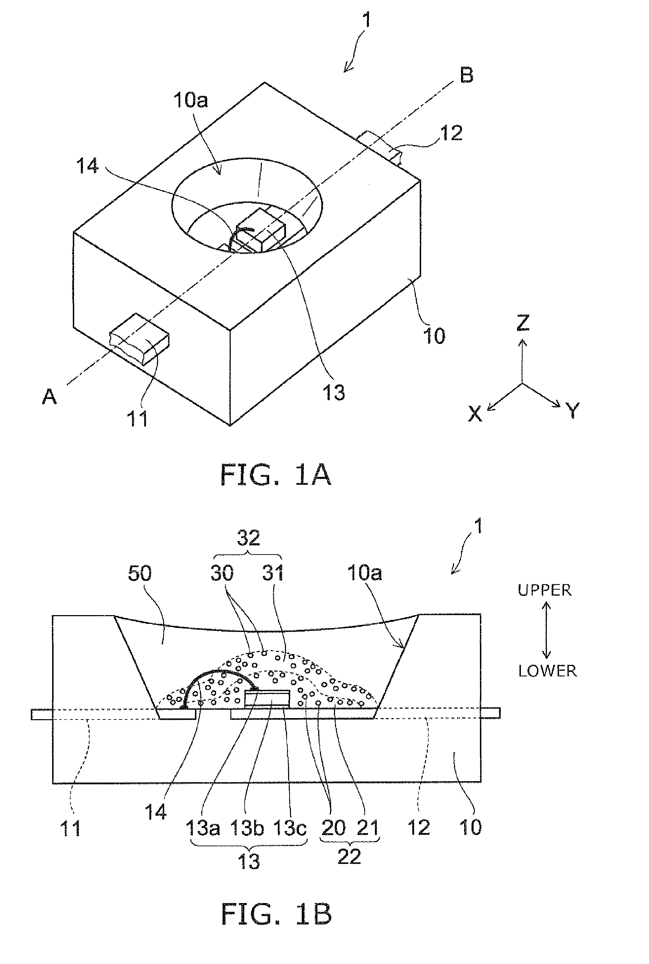

FIGS. 1A and 1B are schematic views of a principal part of a light emitting device according to an embodiment. FIG. 1A is a cubic view of a principal part of a light emitting device 1, FIG. 1B is an A-B cross-sectional view of FIG. 1A. In FIG. 1A, a light emitting element 13 is in exposed-state.

The light emitting device 1 includes a package member 10 as an enclosure. The light emitting device 1 includes the light emitting element 13 provided in the package member 10. The light emitting device 1 includes a first phosphor layer provided on the light emitting element 13 and having a first phosphor. The light emitting device 1 includes a second phosphor layer, having a second phosphor, provided on the first phosphor layer. Here, the first phosphor is, for instance, a phosphor 20. The first phosphor layer is, for instance, a phosphor layer 22. The second phosphor is, for instance, a phosphor 30. The second phosphor layer is, for instance, a phosphor layer 32. A luminescent efficiency of the first phosphor is higher than a luminescent efficiency of the second phosphor. The light emitting device 1 is used, for instance, as a back-light source of a display device.

A luminescent efficiency of a phosphor is defined by a quantum efficiency in this specification. The quantum efficiency means an internal quantum efficiency and an external quantum efficiency. The internal quantum efficiency is expressed by a ratio of generation photon number (B1) to excitation photon number (A1) being absorbed into the phosphor. The external quantum efficiency is expressed by a ratio of external generation photon number (B2) to photon number (A2) irradiating on a surface of the phosphor. That is, the internal quantum efficiency is expressed as (B1/A1), the external quantum efficiency is expressed as (B2/A2). The quantum efficiency increases with increasing at least one of the internal quantum efficiency and the external quantum efficiency.

A lead frame 11 is face-to face with a lead frame 12 in the light emitting device 1. A part of the lead frame 11 and a part of the lead frame 12 are sealed in the package member 10 as the enclosure. One part of the lead frame 11 and one part of the lead frame 12 are exposed from a bottom face of a recess portion 10a. The light emitting element 13 is mounted on the lead frame 12.

The light emitting element 13 includes, for instance, a semiconductor stacked body 13a. The semiconductor stacked body 13a is such as a nitride semiconductor. The semiconductor laminated body 13a is sandwiched between an upper electrode 13b and a lower electrode 13c. The light emitting element 13 is an LED (Light Emitting Diode) chip having a structure including an upper electrode and a lower electrode. The light emitting element 13 emits, for instance, a light in a blue region (440nm to 470nm: not less than 440 nanometers, not more than 470 nanometers).

A conductive bonding material such as a silver paste is provided between the lower electrode 13c and the lead frame 12 (not shown). This electrically connects the lower electrode 13c of the light emitting element 13 to the lead frame 12. The upper electrode 13b of the light emitting element 13 is connected electrically to the lead frame 11 through a bonding wire 14. The upper electrode 13b is made up of, for instance, a bonding pad made of transparent electrode such as ITO (indium tin oxide) and so on, and metal.

External terminals of the lead frames 11, 12 are protruding from the package member 10. When a certain amount of voltage is applied between protruding parts of the lead frames 11, 12, a potential difference occurs between the upper electrode 13b and the lower electrode 13c of the light emitting element 13. This causes primary light to be emitted from the semiconductor stacked body 13a. The emitted primary light is headed in an upper direction of FIG. 1B (for instance, in Z axis direction).

The light emitting element 13 is covered with the phosphor layer 22 having the phosphor 20 dispersed in a resin member 21. The resin member 21 is a binder of the phosphor 20. A portion of the primary light emitted from the light emitting element 13 is absorbed into the phosphor 20, and the primary light is converted into a secondary light whose wavelength is different from the primary light. Therefore, the primary light and the secondary light can be obtained above the phosphor layer 22.

The phosphor layer 22 is covered with the phosphor layer 32 having the phosphor 30 dispersed in a resin member 31. The resin member 31 is a binder of the phosphor 30. A portion of the primary light emitted from the light emitting element 13 is absorbed into the phosphor 30, and the primary light is converted into a tertiary light whose wavelength is different from the primary light. Therefore, a mixed light including the primary light, the secondary light, and the tertiary light can be obtained above the phosphor layer 32. If a color of the primary light is blue, a color of the secondary light is red, and a color of the tertiary light is green, the light emitting device 1 emits the mixed light including these colors. The phosphor layer 32 is covered with a resin member 50 not having the phosphor.

This way, the light emitting device 1 has a multilayer structure that the phosphor layer 32 containing the phosphor 30 is stacked on the phosphor layer 22 containing the phosphor 20 without mixing different types of the phosphor (for instance, the phosphor 20, 30) into a resin member of a single layer. Stacking sequence in the multilayer structure is not limited to above-described examples. However, the phosphor 20 (the phosphor layer 22) with a higher luminescent efficiency is placed on the light emitting element 13 side in order to increase luminance of the light emitting device 1 as illustrated in FIGS. 1A and 1B.

Material of each member of the light emitting device 1 is described below.

For instance, the material of the package member 10 is thermoplastic resin and so on. Each material of the resin member 21, the resin member 31, and the resin member 50 is a material having a refractive index of 1.2-1.9 (not less than 1.2, not more than 1.9), a transmittance of not less than 90% in a wavelength region of 420nm to 720nm (not less than 420 nanometers, not more than 720 nanometers). For instance, each material of the resin member 21, the resin member 31, and the resin member 50 includes epoxy resin, metacrylate resin (PMMA), polycarbonate resin (PC), cyclic polyolefin (COP), alicyclic acrylic (OZ), thermoset resin for lens of eyeglasses (ADC), acrylic resin, fluorine resin, silicone resin, silicon oxide ($SiO_2$) titanium oxide ($TiO_2$).

The fluorescent bodies have luminescence wavelengths in 500nm to 555nm (green region: not less than 500 nanometers, not more than 555 nanometers), 560nm to 580nm (yellow region: not less than 560 nanometers, not more than 580 nanometers), and 600nm to 670nm (red region: not less than 600 nanometers, not more than 670 nanometers). Fluorescent particles (Phosphor particles) contain at least one type of silicon(Si), aluminum(Al), titanium(Ti), germanium (Ge), phosphorus(P), boron(B), yttrium(Y), alkaline-earth element, sulfide, rare-earth element, nitride.

The phosphor 20, for instance, is a phosphor producing fluorescence of red color. Specifically, the phosphor 20 includes phosphors described below.

$Y_2O_2S:Eu$

$Y_2O_2S:Eu$

$Y_2O_2S: Eu$+pigment

$Y_2O_3:Eu$

$Zn_3(PO_4)_2:Mn$

$(Zn,Cd)S:Ag+In_2O_3$

$(Y,Gd,Eu)BO_3$

$(Y,Gd,Eu)_2O_3$

$YVO_4:Eu$

$La_2O_2S:Eu,Sm$

$LaSi_3N_5:Eu^{2+}$

alpha-sialon:$Eu^{2+}$

$CaAlSiN_3:Eu^{2+}$

$CaSiN_x:EU^{2+}$

$CaSiN_x:Ce^{2+}$

$M_2Si_5N_8:Eu^{2+}$

$CaAlSiN_3:E_U^{2+}$

$(SrCa)AlSiN_3:Eu^{x+}$

$Sr_x(Si_yAl_3)z(O_xN):EU^{x+}$

The phosphor 30, for instance, is a phosphor producing fluorescence of green color. Specifically, the phosphor 30 includes phosphors described below.

ZnS:Cu,Al

ZnS:Cu,Al+pigment

$(Zn,Cd)S:Cu,Al$

ZnS:Cu,Au,Al+pigment

$Y_3Al_5O_{12}:Tb$

$Y_3(Al,Ga)_5O_{12}:Tb$

$Y_2SiO_5:Tb$

$Zn_2SiO_4:Mn$

$(Zn,Cd)S:Cu$

ZnS:Cu

$Zn_2SiO_4$:Mn

ZnS:Cu+Zn2SiO$_4$:Mn

$Gd_2O_2S$:Tb

(Zn,Cd)S:Ag

ZnS:Cu,Al

$Y_2O_2S$:Tb

ZnS:Cu,Al+$In_2O_3$

(Zn,Cd)S:Ag+$In_2O_3$

$(Zn,Mn)_2SiO_4$

$BaAl_{12}O_{19}$:Mn

$(Ba,Sr,Mg)O·aAl_2O_3$:Mn

$LaPO_4$:Ce,Tb

$Zn_2SiO_4$:Mn

ZnS:Cu

$3(Ba,Mg,Eu,Mn)O·8Al_2O_3$

$La_2O_3.O·2SiO_2·0·9P_2O_5$:Ce,Tb

$CeMgAl_{11}O_{19}$:Tb

$CaSC_2O_4$:Ce

$(BrSr)SiO_4$:Eu

alpha-sialon:$Yb^{2+}$

beta-sialon:$Eu^{2+}$

$(SrBa)YSi_4N_7$:$Eu^{2+}$

$(CaSr)Si_2O_4N_7$:$Eu^{2+}$

Sr(SiAl)(ON):Ce

The phosphor is more closely placed to the light emitting element 13 with higher luminescent efficiency in the light emitting device 1. For instance, the phosphor layer 22 is placed more closely to the light emitting element 13 than the phosphor layer 32, because the luminescent efficiency of the phosphor 20 is higher than the luminescent efficiency of the phosphor 30. The luminance of the light emitting device 1 unfavorably decrease, if the phosphor, having a lower luminescent efficiency, is placed more closely to the light emitting element 13.

Next, a method of adjusting a total weight G2(g:gram) and a total weight G3(g) is described. The total weight G2(g) is a total weight of the phosphor 20 in the phosphor layer 22. The total weight G3(g) is a total weight of the phosphor 30 in the phosphor layer 32. The total weights G2, G3 are accordingly adjusted depending on a wavelength $\lambda$(nm) or an emission intensity P(W/nm) of the light emitting element 13.

In this embodiment, database are made concerning relationships between the wavelength $\lambda$ or the emission intensity P of the light emitting element 13, the total weight G2 of the phosphor 20, or the total weight G3 of the phosphor 30 and chromaticities Cx, Cy of the light emitting device 1. When these databases are compiled, even if the wavelength A or the emission intensity P of the light emitting element 13 varies, the total weight G2 of the phosphor 20 or the total weight G3 of the phosphor 30 is adjusted and a light emitting device with the suppressed variation of chromaticities (Cx, Cy) is formed.

A plurality of light emitting devices 1 are prepared to compile the databases. The wavelength A or the emission intensity P of the light emitting element 13, the total weight G2 of the phosphor 20, or the total weight G3 of the phosphor 30 differs from each other in each of light emitting devices slightly. And the relationships between the respective data are determined. The relationships may be obtained by experiments or computer simulations. The total weight G2(g) of the phosphor 20 is replaced by ( (a density N2(g/cm$^3$) of the phosphor 20) x (a coating quantity V2(cm$^3$) of the phosphor 20)). The total weight G3(g) of the phosphor 30 is replaced by ( (a density N3(g/cm$^3$) of the phosphor 30) x (a coating quantity V3(cm$^3$) of the phosphor 30) ). That is, each coating quantity is determined depending on a capacity of the recess potion 10a of the package member 10. Furthermore, the density of each phosphor is determined depending on the total weight and the coating quantity in each of the fluorescent bodies. The coating quantity is defined by a capacity (cm$^3$) of the resin member in which the phosphor is dispersed.

In compiling the databases, the wavelength $\lambda$ and the emission intensity P of the light emitting element 13 of each of the light emitting devices 1 are previously measured before forming the fluorescent boy layers 22, 23. And, a spectrum (an emission spectrum of a mixed light) radiated from each of the light emitting devices 1 is measured, parameterizing the wavelength $\lambda$ of the light emission element 13, the emission intensity P of the light emission element 13, the total weight of the phosphor layers 22, 23. This determines the relationships between each of the spectrums and the wavelength $\lambda$ or the emission intensity P of each of the light emission elements 13, the total weight G2 of the phosphor 20 and the total weight G3 of the phosphor 30.

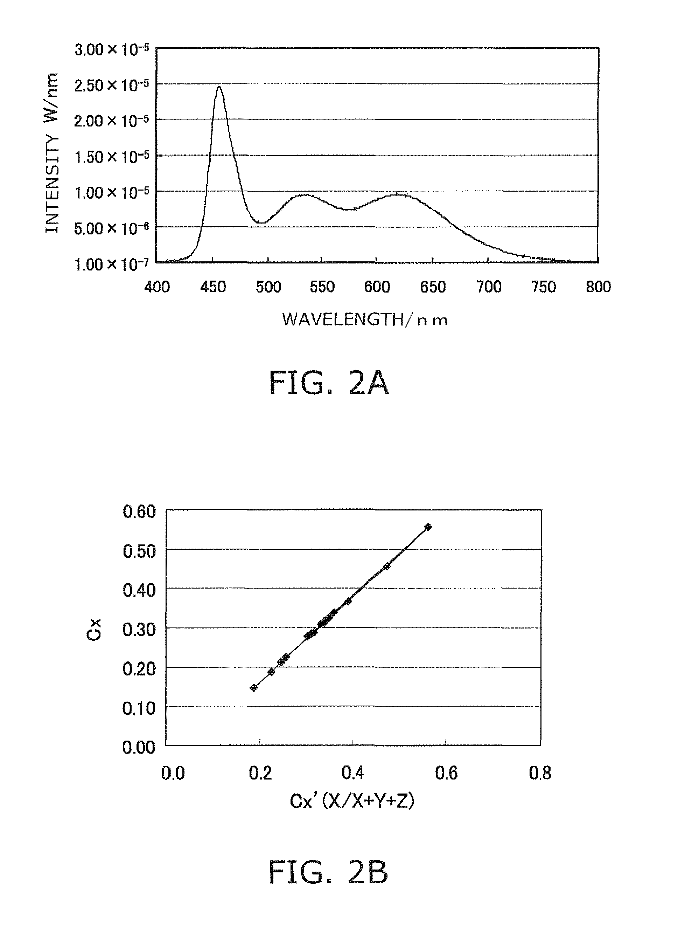

For instance, FIGS. 2A and 2B are views for describing compiling databases.

The spectrum of the light emitting device having a predetermined wavelength A, emission intensity P, total weight G2, and total weight G2 is shown in FIG. 2A. Here, the horizontal axis of FIG. 2A represents wavelength(nm). The vertical axis represents emission intensity(W/nm).

Next, a red color intensity Ir, a green color intensity Ig, and a blue color intensity Ib of each of the light emitting devices are measured respectively by using each of spectrums. A level of the red color intensity Ir depends on the total weight G2 of the phosphor 20. A level of the green color intensity Ig depends on the total weight G3 of the phosphor 30. A level of the blue color intensity Ib depends on the emission intensity P of the light emitting element 13.

In this embodiment, a red stimulus value X, a green stimulus value Y, and a blue stimulus value Z are defined as next (1)-(3) expressions. The red color intensity Ir, the green color intensity Ig, and the blue color intensity Ib are multiplied by xr, xg, xb, yr, yg, yb, zr, zg, and zb as factors of color-matching function in next expressions.

$$\text{(the red stimulus value X)} = xr \times \text{(the red color intensity Ir)} + xg \times \text{(the green color intensity Ig)} + xb \times \text{(the blue color intensity Ib)} \cdots eq.(1)$$

$$\text{(the green stimulus value Y)} = yr \times \text{(the red color intensity Ir)} + yg \times \text{(the green color intensity Ig)} + yb \times \text{(the blue color intensity Ib)} \cdots eq.(2)$$

$$\text{(the blue stimulus value Y)} = zr \times \text{(the red color intensity Ir)} + zg \times \text{(the green color intensity Ig)} + zb \times \text{(the blue color intensity Ib)} \cdots eq.(3)$$

In this embodiment, temporary chromaticities (Cx', Cy') are defined as next (4)-(5) expressions. The red stimulus value X, the green stimulus value Y, and the blue stimulus value Y are used in next expressions.

$$Cx' = \text{(the red stimulus value X)}/((\text{ the red stimulus value X)} + \text{(the green stimulus value Y)} + \text{(the blue stimulus value Y))} \cdots eq.(4)$$

$$Cy' = \text{(the green stimulus value Y)}/((\text{ the red stimulus value X)} + \text{(the green stimulus value Y)} + \text{(the blue stimulus value Y))} \cdots eq.(5)$$

For instance, the higher the total weight of the phosphor 20 is, the higher Cx' will be. The lower the total weight of the phosphor 20 is, the lower Cx' will be. For instance, the higher the total weight of the phosphor 30 is, the higher Cy' will be. The lower the total weight of the phosphor 30 is, the lower Cx' will be.

The values of (Cx', Cy') differ from each of spectrums. Therefore, the databases of the relationship between the values of (Cx', Cy') and the wavelength A, the emission intensity P, the total weights G2, or the total weights G3 are made.

Next, the choromaticities of Cx, Cy of a light emitted from each of the light emitting devices 1 are measured with a chromoscope meter. This determines the relationship between (Cx, Cy) and (Cx', Cy').

Concerning the relationship between Cx and Cx', factors xr, xg, xb, yr, yg, yb, zr, zg, and zb are accordingly adjusted so as to obtain a linear relation between Cx and Cx'. Concerning the relationship between Cy and Cy', factors xr, xg, xb, yr, yg, yb, zr, zg, and zb are accordingly adjusted so as to obtain a linear relation between Cy and Cy'.

FIG. 2B shows a linear relation between Cx and Cx'. The linear relation between Cy and Cy' is also determined at this stage (not shown).

If obtaining a number of lines of the linear relation with respect to each of the wavelengths A or the emission intensities P in the light emitting elements 13, the values of Cx', Cy' corresponding to the values of Cx= Cy=0.33 are determined reversely even if the wavelengths λ or the emission intensities P varies. The light emitting device, emitting the desired incandescent light (for instance, Cx=Cy=0.33), can be obtained stably by determining the total weight G2 of the phosphor 20 and the total weight G3 of the phosphor 30 from the reversed Cx', Cy'.

This way, the dependence property is determined previously before constructing the light emitting device 1. The dependence property is the dependence of chromaticities of the mixed light emitted from the light emitting element 13, the phosphor 20, and the phosphor 30 on the wavelength A or the emission intensity P of the light emitting element 13, the total weight G2 of the phosphor 20, or the total weight G3 of the phosphor 30.

A method of manufacturing the light emitting device 1 is described below.

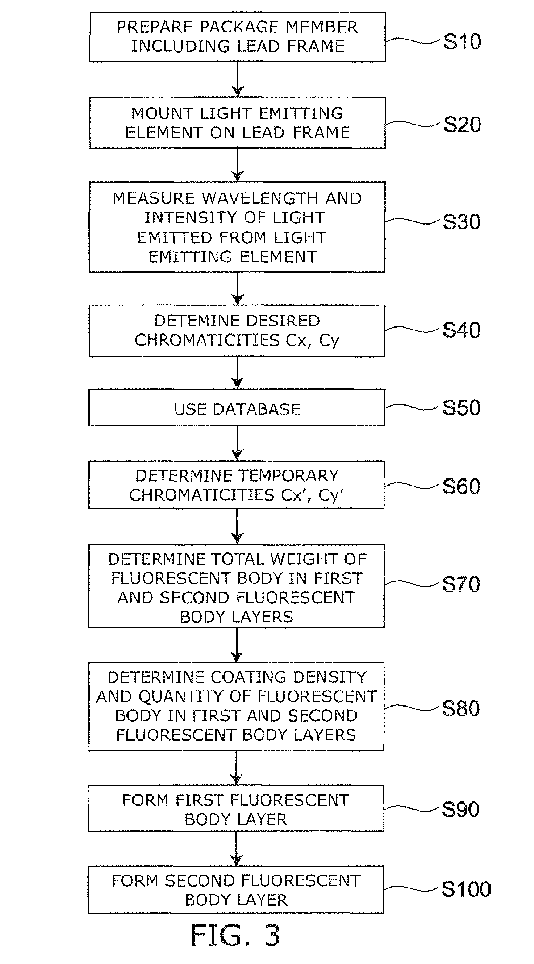

FIG. 3 is a flowchart diagram for describing a process for manufacturing the light emitting device.

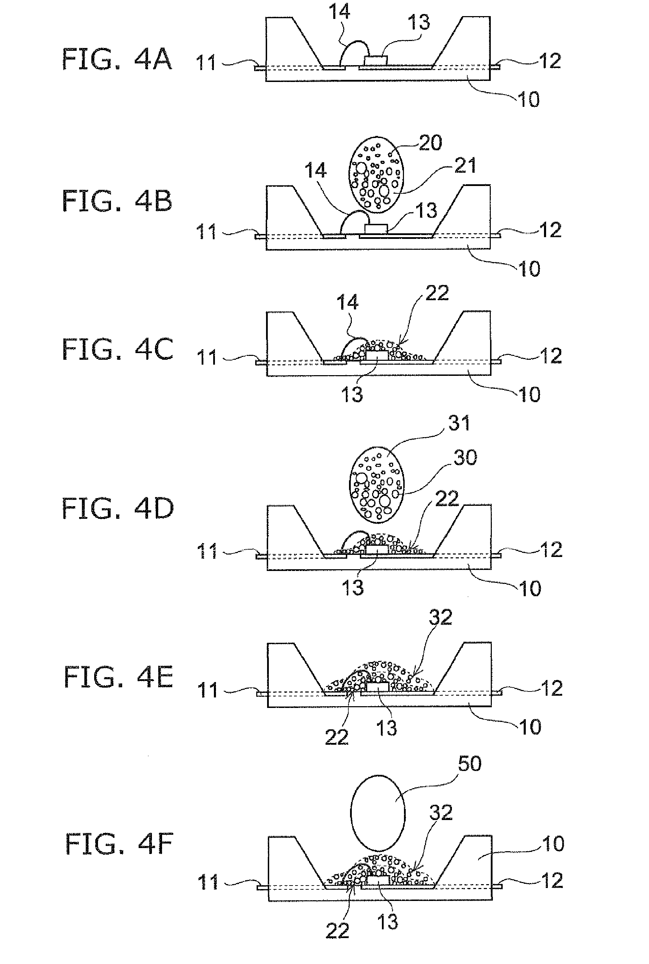

FIGS. 4A to 4F are schematic views of a principal part for describing the process for manufacturing the light emitting device.

The package member 10 including the lead frames 11, 12 is prepared as shown in FIG. 4A (step 10). Subsequently, the light emitting element 13 is mounted on the lead frame 12 (step 20). Thus, the light emitting element 13 is provided in the package member 10 as the enclosure. The light emitting element 13 is connected to the lead frame 11 through the bonding wire 14.

A blue LED is used as the light emitting element 13. The blue LED is produced to emit a light of 450 nm as a target wavelength. The wavelength A and the emission intensity P of the light emitted from the light emitting element 13 are measured at this stage (step 30). The wavelength A and the emission intensity P of the light emitting element 13 are measured before forming the phosphor layers 22, 32, supposing that the wavelength A from the light emitting element 13 varies between not less than 440 nm and not more than 460 nm. The wavelength A and the emission intensity P of the light emitted from the light emitting element 13 may be measured before mounting the light emitting element 13 on the lead frame 12. At this point, the relationship between the wavelength λ or the emission intensity P of the light emitting element 13 and Cx', Cy', Cx, and Cy is previously determined as the detabases.

Next, desired chromaticities are determined (step 40). The target is to manufacture the light emitting device which has the values of Cx=Cy=0.33 as an example. The condition of Cx=Cy=0.33 satisfies requirements for the incandescent light.

And the databases are used (step 50) to determine the temporary chromaticities Cx', Cy' corresponding to the values of Cx=Cy=0.33 (step 60). After that, the total weights of the phosphor 20, 30 are determined (step 70) so as to satisfy requirements for the incandescent light (Cx=Cy=0.33). This way, the total weight G2 of the phosphor 20 and the total weight G3 of the phosphor 30 are determined respectively so that the mixed light from the light emitting device 1 having measured wavelength A and emission intensity P has prescribed chromaticity.

Furthermore, the coating quantity V2 is determined depending on the capacity of the recess portion 10a in the package member 10 or a configuration of the light emitting element 13. The density N2 of the phosphor 20 is determined depending on the total weight G2 of the phosphor 20 and the coating quantity V2. The coating quantity V3 is determined depending on the capacity of the recess portion 10a in the package member 10 or the configuration of the light emitting element 13. The density N3 of the phosphor 30 is determined depending on the total weight G3 of the phosphor 30 and the coating quantity V3 (step 80).

In this embodiment, the phosphor layers with the higher luminescent efficiency with respect to the light emitting element 13 is stacked sequentially on the light emitting element 13 in order to increase the emission intensity of the light emitting device 1. For instance, a drop of the resin member 21, in which the phosphor 20 is dispersed, is put from the upper side of the light emitting element 13 as shown in FIG. 4B, because the luminescent efficiency of the phosphor 20 is higher than the luminescent efficiency of the phosphor 30. The resin member 21 having the phosphor 20 dispersed therein is paste-like.

After falling in drops, a centrifugal sedimentation (650 rpm, 30 minutes) is given to the resin member 21 in which the phosphor 20 is dispersed. This forms the phosphor layer 22 as the first phosphor layer as shown in FIG. 4C (step 90). In the result, at least one part of the light emitting element 13 is covered with the phosphor layer 22.

Next, a drop of the resin member 31, in which the phosphor 30 is dispersed, is put from the upper side of the phosphor layer 22 as shown in FIG. 4D. The resin member 31 having the phosphor 30 dispersed therein is paste-like. After the drop, the centrifugal sedimentation (650 rpm, 30 minutes) is given to the resin member 31 in which the phosphor 30 is dispersed. Thus, the phosphor layer 32 as the second phosphor layer is formed as shown in FIG. 4E (step 100). In the result, at least one part of the phosphor layer 22 is covered with the phosphor layer 32. The drop of the resin member containing the phosphor is delivered from a nozzle not shown.

Next, a drop of the resin member 50 is put from the upper side of the phosphor layer 32 as shown in FIG. 4F. This forms the light emitting device 1 having the phosphor layer 32 covered with the resin member 50 as shown in FIG. 1. The resin member 21, the resin member 31, and the resin member 50 are cured finally. Each of the resin members 21, 31, 50 may be cured individually after each falling in drops of the resin members 21, 31, 50. The resin members 21, 31, 50 may be cured simultaneously. The method of curing is illustratively thermal curing.

According to the manufacturing method like this, the light emitting device 1, having desired chromaticities, is provided by correcting the density or the coating quantity of the phosphor optimally, even if the wavelength A or the emission intensity P of the light emitting element 13 of every light emitting device varies.

In this embodiment, the total weight of the phosphor, which has a relatively sensitive dependence on the wavelength A of the light emitting element 13, is adjusted preferentially to suppress the variation of chromaticities. For instance, the total weight of the phosphor 20 is adjusted preferentially in the case where the phosphor 20 has a more sensitive dependence on the wavelength A than the phosphor 30.

Other manufacturing methods described below are involved in this embodiment.

The phosphor layers 22, 32 become more symmetrical and uniform with respect to a center of the light emitting element 13 according to the manufacturing method described below.

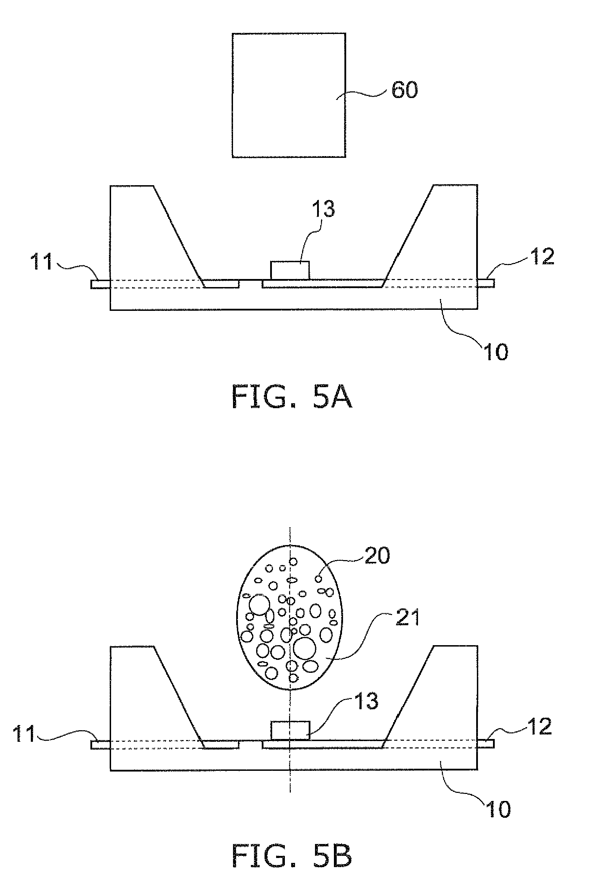

FIGS. 5A and 5B are schematic views of a principal part for describing the process for manufacturing the light emitting device.

For instance, as shown in FIG. 5A, a surface profile and a position of the light emitting element 13 are detected with an image recognition unit 60 such as a camera and so on before the drop of the resin member 21, in which the phosphor 20 is dispersed, is put on the upper side of the light emitting element 13. And, as shown in FIG. 5B, the drop of the resin member 21, in which the phosphor 20 is dispersed, is delivered at the detected central portion of the light emitting element 13 as a target. A similar process described above is conducted for the resin member 31 in which the phosphor 30 is dispersed.

This surely prevents position misalignment of the resin member 21, 31 having the fluorescent bodies 20, 30 dispersed therein to the light emitting element 13 are prevented certainly. In the result, the phosphor layers 20, 30 become more symmetrical and uniform with respect to the center of the light emitting element 13, and the light emitting device is improved in quality.

Alternatively, a method such that the recess portion 10a of the package member 10 is filled with the resin member 50 not having the phosphor before the drop of the resin member 21, in which the phosphor 20 is dispersed, is put on the upper side of the light emitting element 13 is also included in this embodiment.

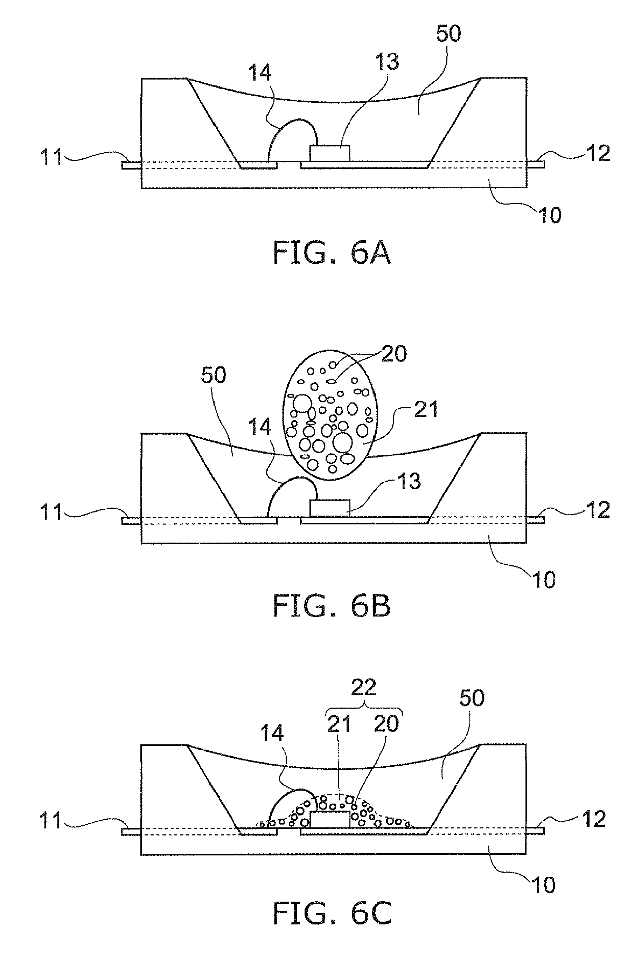

FIGS. 6A to 6C are schematic views of a principal part for the process for manufacturing the light emitting device.

For instance, as shown in FIG. 6A, the recess portion 10a of the package member 10 is filled with the resin member 50 not having the phosphor before the drop of the resin member 21, in which the phosphor 20 is dispersed, is put on the upper side of the light emitting element 13. A resin member, having a lower specific weight than the resin member 21, is selected as the resin member 50. Subsequently, the drop of the resin member 21, in which the phosphor 20 is dispersed, is put on the resin member 50. Then, the resin member 21, in which the phosphor 20 is dispersed, remains at the central portion of the resin member 50 in a spherical shape as shown in FIG. 6B. The resin member 21 tends to adhere to an inside wall of the recess portion 10a due to a surface tension of the resin member 21 if the recess portion 10a is not filled with the resin member 50. That is, adhesion of the resin member 21 to the inside wall is decreased by filling the recess portion 10a with the resin member 50 preliminary.

That is, the resin member 21, in which the phosphor 20 is dispersed, moves to the central portion of the resin member 50 by self-alignment, even if the position of the resin member 21 gets into misalignment from the central portion of the light emitting element 13 after falling in drops of the resin member 21. The centrifugal sedimentation is run to centrifugalize the resin member 21, in which the phosphor 20 is dispersed, to the light emitting element 13 side. In the result, the phosphor layer 22 becomes more symmetrical and more uniform with respect to the center of the light emitting element 13 as shown in FIG. 6C. If the similar operation is also given to the resin member, in which the phosphor 30 is dispersed, the phosphor layer 32 becomes more symmetrical and more uniform with respect to the center of the light emitting element 13. This improves the light emitting device in quality.

(Second Embodiment)

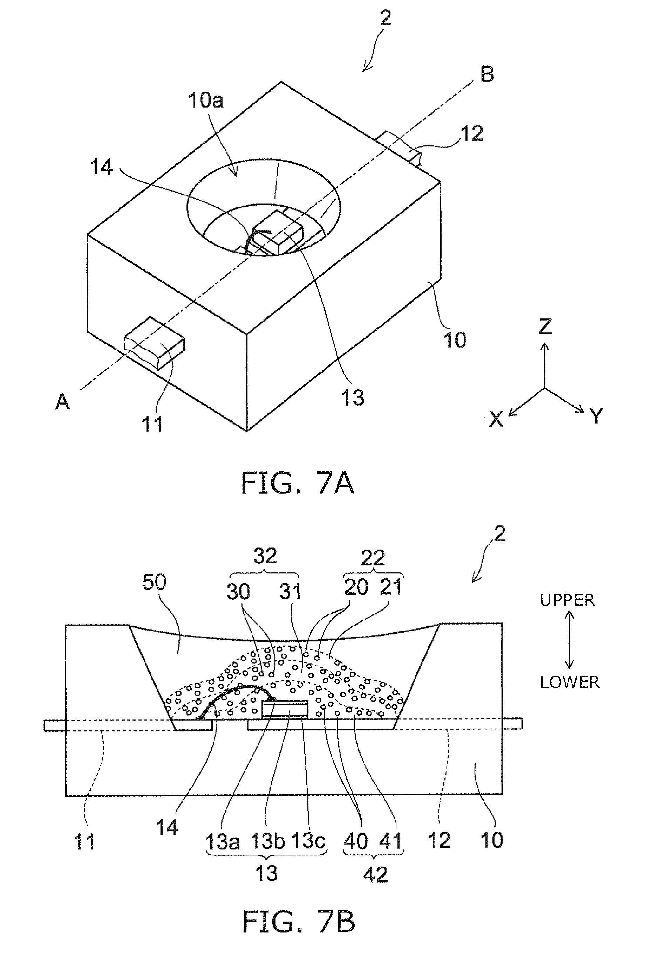

FIGS. 7A and 7B are schematic views of a principal part of a light emitting device according to an embodiment. FIG. 7A is a cubic view of a principal part of a light emitting device 2, FIG. 7B is an A-B cross-sectional view of FIG. 7A. The light emitting element 13 is in exposed-state in FIG. 7A.

The light emitting device 2 includes the phosphor layers 22, 32, and a third phosphor layer 42 which has a phosphor 40 as a third phosphor. The phosphor layer 42 is provided on the light emitting element 13. The luminescent efficiency of the phosphor 20 is higher than the luminescent efficiencies of the fluorescent bodies 30, 40. The light emitting device 2 is illustratively used as a back-light source of a display device. The light emitting element 13 of the light emitting device 2 is an LED chip emitting a light in UV (ultraviolet) region. For instance, the light emitting element 13 emits a light in a region of 350nm to 410nm (not less than 350 nanometers, not more than 410 nanometers).

The light emitting element 13 is covered with the phosphor layer 42 having the phosphor 40 dispersed in a resin member 41. The phosphor layer 42 is covered with the phosphor layer 32 having the phosphor 30 dispersed in a resin member 31. The phosphor layer 32 is covered with the phosphor layer 22 having the phosphor 20 dispersed in a resin member 21. A portion of primary light emitted from the light emitting elements 13 is absorbed into the phosphor 40, and the primary light is converted into secondary light whose wavelength is different from the primary light. Therefore, the primary light and the secondary light can be obtained above the phosphor layer 42. A portion of the primary light emitted from the light emitting element 13 is absorbed into the phosphor 30, and the primary light is converted into tertiary light whose wavelength is different from the primary light. Therefore, the primary light, the secondary light, and the tertiary light can be obtained above the phosphor layer 32. A portion of the primary light emitted from the light emitting element 13 is absorbed into the phosphor 20, and the primary light is converted into quartic light whose wavelength is different from the primary light. Therefore, a mixed light, including the primary light, the secondary light, the tertiary light, and the quartic light, can be obtained above the phosphor layer 22.

If the primary light is ultraviolet light, a color of the secondary light is blue, a color of the tertiary light is green, and a color of the quartic light is red, the light emitting device 2 emits the mixed light including these colors. The phosphor layer 22 is covered with the resin member 50.

This way, the light emitting device 2 has a multilayer structure that the phosphor layer 32 is accumulated on the phosphor layer 42, and the phosphor layer 22 is accumulated on the phosphor layer 32 above the light emitting element 13. Different types of the phosphor, such as the phosphor 20, 30, 40 are not mixed into a single resin layer in the light emitting device 2.

The phosphor 40, for instance, is a phosphor producing fluorescence of blue color, and specifically, the phosphor 40 is at least one of below-described phosphors. The phosphor 40 has a luminescence wavelength in 440nm to 470nm (not less than 440 nanometers, not more than 470 nanometers). The light emitting element 13 emits light having the luminescent wavelength in the ultraviolet region. In addition to the phosphor layers 22, 32, the light emitting device 2 includes the phosphor layer 42 emitting blue-light. Therefore, chromatic selectivity (in other words, chromaticitiy space or chromaticity range) becomes more wide in the blue-light region.

$ZnS:Ag$

$ZnS:Ag+pigment$

$ZnS:Ag,Al$

$ZnS:Ag,Cu,Ga,Cl$

$ZnS:Ag+In_2O_3$

$ZnS:Zn+In_2O_3$

$(Ba,Eu)MgAl_{10}O_{17}$

$(Sr,Ca,Ba,Mg)_{10}(PO_4)_6Cl_2:Eu$

$Sr_{10}(PO_4)_6C_{12}:Eu$

$(Ba,5r,Eu)(Mg,Mn)Al_{10}O_{17}$

$10(Sr,Ca,Ba,Eu)-6PO_4-C_{12}$

$BaMg_2Al_{16}O_{25}:Eu$

Stacking sequence of the phosphor layer 22, the phosphor layer 32 and the phosphor layer 42 is not limited to above-described examples in the light emitting device 2. However, the phosphor may be more closely placed to the light emitting element 13 with higher luminescent efficiency so as to increase luminance of the light emitting device 2. The luminescent efficiency of the phosphor 20 is higher than the luminescent efficiencies of the phosphor 30, 40. Therefore, the phosphor layer 22, the phosphor layer 32, and the phosphor layer 42 may be stacked in this order, in a direction from the light emitting element 13 to the resin member 50. The sequence of the phosphor layers in a direction from the resin member 50 to the light emitting element 13 corresponds to the order of the ascending luminescent efficiency. Such structures are included in this embodiment.

The method of adjusting the total weight G2(g) in the phosphor layer 22, the total weight G3(g) in the phosphor layer 32 and a total weight G4(g) in the phosphor layer 42 is described. These total weights G2, G3, G4 are accordingly adjusted depending on the wavelength $\lambda$(nm) or the emission intensity P(W/nm) of the light emitting element 13.

In this embodiment, databases are made about relationships between the wavelength $\lambda$ or the emission intensity P of the light emitting element 13, the total weight G2 of the phosphor 20, the total weight G3 of the phosphor 30, or the total weight G4 of the phosphor 40 and chromaticities Cx, Cy of the light emitting device 2. By compiling these databases, even if the wavelength A or the emission intensity P of the light emitting element 13 varies, the total weight G2 of the phosphor 20 or the total weight G3 of the phosphor 30 is adjusted and a light emitting device with the suppressed variation of chromaticities (Cx, Cy).

A plurality of light emitting devices 2are prepared to compile the databases. The wavelength $\lambda$ or the emission intensity P of the light emitting element 13, the total weight G2 of the phosphor 20, the total weight G3 of the phosphor 30, or the total weight G4 of the phosphor 40 differs from each other in each of light emitting devices slightly. And the relationships between the respective data are determined. The relationships may be obtained by experiments or computer simulations. The total weight G2(g) of the phosphor 20 is replaced by ((the density N2(g/cm$^3$) of the phosphor 20) x (the coating quantity V2(cm$^3$) of the phosphor 20)). The total weight G3(g) of the phosphor 30 is replaced by ((the density N3(g/cm$^3$) of the phosphor 30) x (the coating quantity V3(cm$^3$) of the phosphor 30)). The total weight G4(g) of the phosphor 40 is replaced by ((a density $N4(g/cm^3)$ of the phosphor 40) x (a coating quantity $V4(cm^3)$ of the phosphor 30)). When each total weight is determined, each coating quantity is determined depending on the capacity of the recess potion 10a of the package member 10. Furthermore, the density of each phosphor is determined depending on the total weight and the coating quantity in each of the fluorescent bodies.

In compiling the databases, the wavelength A and the emission intensity P of the light emitting element 13 of each of the light emitting devices 2 are previously measured before forming the phosphor layers 22, 32 and 42. And, a spectrum (an emission spectrum of a mixed light) radiated from each of the light emitting devices 2 is measured, parameterizing the wavelength A of the light emission element 13, the emission intensity P of the light emission element 13, the total weight of the phosphor layers 22,32 and 42. This determines the relationships between each of the spectrums and the wavelength A or the emission intensity P of each of the light emission elements 13, the total weight G2 of the phosphor 20, the total weight G3 of the phosphor 30 and the total weight G4 of the phosphor 40.

For instance, the red color intensity Ir, the green color intensity Ig, and the blue color intensity Ib of each of the light emitting devices 2 are measured respectively by using the spectrum as shown in FIG. 2A. The level of the red color intensity Ir depends on the total weight G2 of the phosphor 20. The level of the green color intensity Ig depends on the total weight G3 of the phosphor 30. The level of the blue color intensity Ib depends on the total weight G4 of the phosphor 40.

In this embodiment, the red stimulus value X, the green stimulus value Y, and the blue stimulus value Z are defined as next (1)-(3) expressions. The red color intensity Ir, the green color intensity Ig, and the blue color intensity Ib are multiplied by xr, xg, xb, yr, yg, yb, zr, zg, and zb as factors of color-matching function in next expressions.

$$\text{(the red stimulus value X)} = xr \times \text{(the red color intensity Ir)} + xg \times \text{(the green color intensity Ig)} + xb \times \text{(the blue color intensity Ib)} \cdots eq.(1)$$

$$\text{(the green stimulus value Y)} = yr \times \text{(the red color intensity Ir)} + yg \times \text{(the green color intensity Ig)} + yb \times \text{(the blue color intensity Ib)} \cdots eq.(2)$$

$$\text{(the blue stimulus value Y)} = zr \times \text{(the red color intensity Ir)} + zg \times \text{(the green color intensity Ig)} + zb \times \text{(the blue color intensity Ib)} \cdots eq.(3)$$

In this embodiment, temporary chromaticities (Cx', Cy') are defined as next (4)-(5) expressions. The red stimulus value X, the green stimulus value Y, and the blue stimulus value Y are used in next expressions.

$$Cx' = \text{(the red stimulus value X)}/(( \text{the red stimulus value X)} + \text{(the green stimulus value Y)} + \text{(the blue stimulus value Y))} \cdots eq.(4)$$

$$Cy' = \text{(the green stimulus value Y)}/(( \text{the red stimulus value X)} + \text{(the green stimulus value Y)} + \text{(the blue stimulus value Y))} \cdots eq.(5)$$

The values of (Cx', Cy') differ from each of spectrums. The databases of the relationship between the values of (Cx', Cy') and the wavelength A, the emission intensity P, the total weights G2, or the total weights G3 are made.

Next, the values of (Cx, Cy) of the light emitted from each of the light emitting devices 2 are measured with the chromoscope meter. This determines the relationship between (Cx, Cy) and (Cx', Cy').

As described above, concerning the relationship between Cx and Cx', and the relationship between Cy and Cy', the adjustment is performed so that the linear relation is obtained.

If obtaining a number of lines of the linear relation with respect to each of the wavelengths A or the emission intensities P in the light emitting elements 13, the values of Cx', Cy' corresponding to the values of Cx=Cy=0.33 are determined reversely even if the wavelengths A or the emission intensities P varies. The light emitting device, emitting the desired incandescent light (for instance, Cx=Cy=0.33), can be obtained stably by determining the total weight G2 of the phosphor 20, the total weight G3 of the phosphor 30, and the total weight G4 of the phosphor 40 from the reversed Cx', Cy'.

This way, the dependence property is determined previously before constructing the light emitting device 1. The dependence property is the dependence of chromaticities of the mixed light emitted from the light emitting element 13, the phosphor 20, the phosphor 30, and the phosphor 40 on the wavelength A or the emission intensity P of the light emitting element 13, the total weight G2 of the phosphor 20, the total weight G3 of the phosphor 30, or the total weight G4 of the phosphor 40.

A method of manufacturing the light emitting device 2 is described.

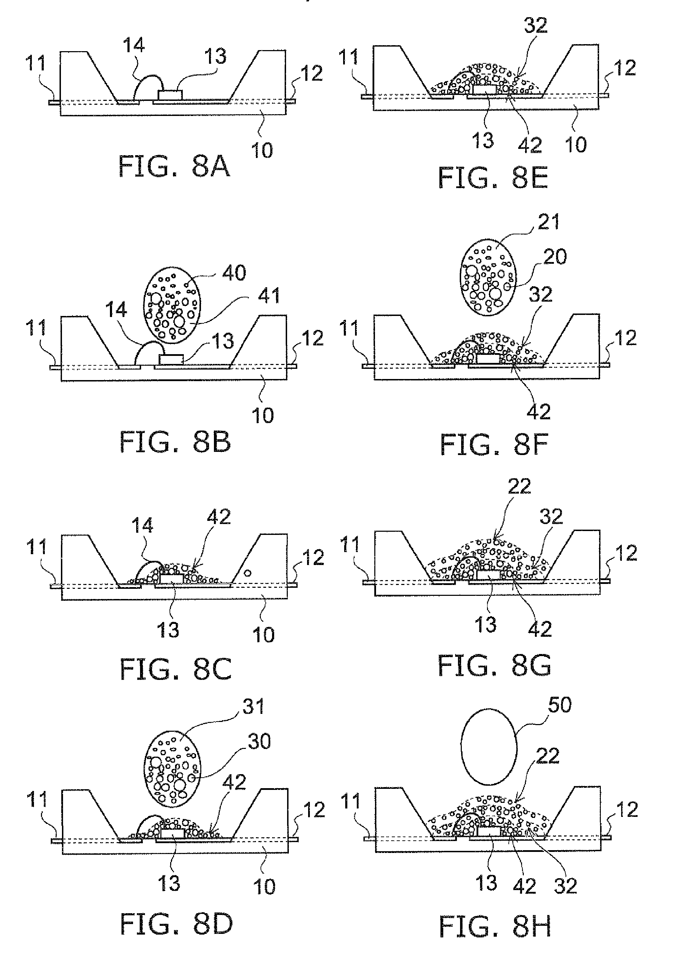

FIGS. 8A to 8H are schematic views of a principal part for describing a process of manufacturing the light emitting device.

The package member 10 is prepared as shown in FIG. 8A. The package member 10 includes the lead frames 11, 12. Subsequently, the light emitting element 13 is mounted on the lead frame 12. The light emitting element 13 is connected to the lead frame 11 through the bonding wire 14. Thus, the light emitting element 13 is placed in the package member 10 as the enclosure. The wavelength A and the emission intensity P of the light emitted from the light emitting element 13 are measured at this stage. The wavelength $\lambda$ and the emission intensity P of the light emitting element 13 are measured before forming the phosphor layers 22, 32, 42, supposing that the wavelength $\lambda$ from the light emitting element 13 varies in a range of 380 nm to 400 nm (not less than 380 nm and not more than 400 nm). The relationship is previously determined as the detabases between the wavelength $\lambda$ or the emission intensity P of the light emitting element 13 and Cx', Cy', Cx, Cy.

Next, desired chromaticities are determined. The target is to fabricate the light emitting device which has the values of Cx=Cy=0.33 as an example. The condition of Cx=Cy=0.33 satisfies requirements for the incandescent light.

And the databases are used to determine the temporary chromaticities Cx', Cy' corresponding to the values of Cx=Cy=0.33. After that, the total weights of the phosphor 20, 30, 40 are determined. The condition of the total weights G2, G3, G4 satisfies requirements for the incandescent light (Cx=Cy=0.33).

Furthermore, the coating quantity V2 is determined depending on the capacity of the recess portion 10a in the package member 10 or the configuration of the light emitting element 13. The density N2 of the phosphor 20 is determined depending on the total weight G2 of the phosphor 20 and the coating quantity V2. The coating quantity V3 is determined depending on the capacity of the recess portion 10a in the package member 10 or the configuration of the light emitting element 13. The density N3 of the phosphor 30 is determined depending on the total weight G3 of the phosphor 30 and the coating quantity V3. The coating quantity V4 is determined depending on the capacity of the recess portion 10a in the package member 10 or the configuration of the light emitting element 13. The density N4 of the phosphor 40 is determined depending on the total weight G4 of the phosphor 40 and the coating quantity V4.

This way, the total weight G2 of the phosphor 20, the total weight G3 of the phosphor 30, and the total weight G4 of the phosphor 40 is determined individually based on the dependence property (databases) so that chromaticities of the mixed light become predetermined values. The mixed light includes the wavelength $\lambda$ and the emission intensity P of the light emitting element 13 which is measured.

Next, a drop of the resin member 41, in which the phosphor 40 is dispersed, is put from the upper side of the light emitting element 13 as shown in FIG. 8B. The resin member 41 having the phosphor 40 dispersed therein is paste-like. After the drop, the centrifugal sedimentation (650 rpm, 30 minutes) is given to the resin member 41 in which the phosphor 40 is dispersed, and at least a part of the light emitting element 13 is covered with the phosphor layer 42 as shown in FIG. 8C.

Next, the drop of the resin member 31, in which the phosphor 30 is dispersed, is put from the upper side of the phosphor layer 42 as shown in FIG. 8D. After the drop, the centrifugal sedimentation is given to the resin member 31 in which the phosphor 30 is dispersed, and at least a part of the phosphor layer 42 is covered with the phosphor layer 32 as shown in FIG. 8E.

Next, the drop of the resin member 21, in which the phosphor 20 is dispersed, is put from the upper side of the phosphor layer 32 as shown in FIG. 8F. After the drop, the centrifugal sedimentation is given to the resin member 21 in which the phosphor 20 is dispersed. In result, at least one part of the surface of the phosphor layer 32 is covered with the phosphor layer 22 as shown in FIG. 8G.

Next, the drop of the resin member 50 is put from the upper side of the phosphor layer 22 as shown in FIG. 8H. Thus, the light emitting device 2 having the phosphor layer 22 covered with the resin member 50 is formed as shown in FIGS. 7A and 7B . The resin member 21, the resin member 31, the resin member 41, and the resin member 50 are cured. Each of the resin members 21, 31, 41, 50 may be cured individually after each drop of the resin members 21, 31, 41, 50. The resin members 21, 31, 41, 50 may be cured simultaneously. The drops of the resin members 21, 31, 41, 50 are delivered from a nozzle not shown.

In this embodiment, stacking sequence of the phosphor layers 22, 32, 42 is not limited to above-described examples. For instance, in order to increase the emission intensity of the light emitting device 2 as a final configuration, the phosphor layers with the higher luminescent efficiency with respect to the light emitting element 13 may be stacked sequentially.

According to the method like this, the light emitting device 2, whose variation of chromaticities is suppressed, is formed by correcting the density or the coating quantity of the phosphor, even if the wavelength A or the emission intensity P of the light emitting element 13 varies.

In this embodiment, the total weight of the phosphor, which has relatively-severer sensitivity dependence (chromaticity dependence) on the wavelength A of the light emitting element 13, is adjusted preferentially to suppress the variation of chromaticities.

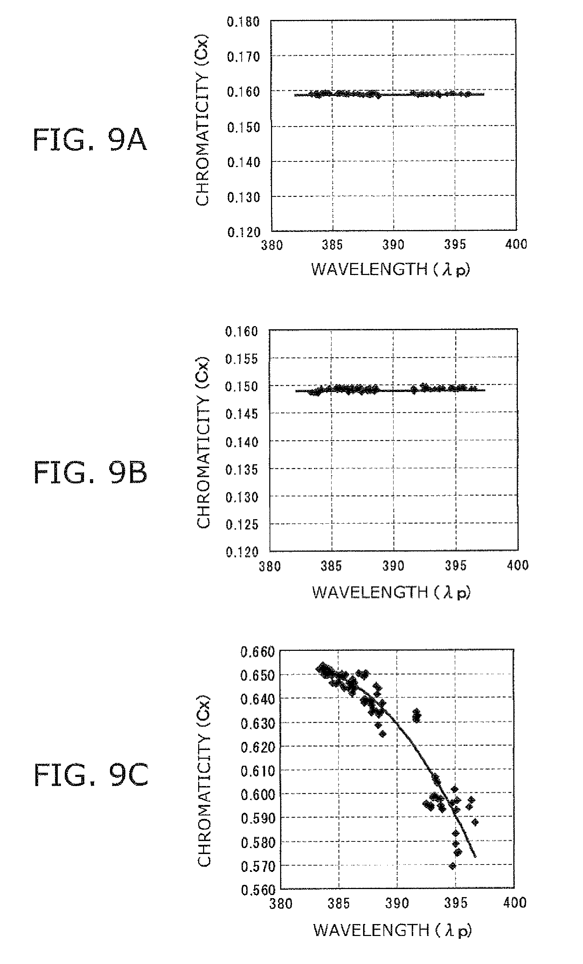

For instance, FIGS. 9A to 9C are views for describing relationship between wavelength and chromaticity.

The horizontal axis of FIGS. 9A to 9C means wavelength $\lambda$ (380nm to 400nm) of the light emitting element 13. The vertical axis means chromaticity Cx.

The relationship is shown between wavelengths $\lambda$ of the light emitting element 13 and chromaticities Cx, concerning the phosphor 40 (blue phosphor) in FIG. 9A. The relationship is shown between wavelengths $\lambda$ of the light emitting element 13 and chromaticities Cx, concerning the phosphor 30 (green phosphor) in FIG. 9B. The relationship is shown between wavelengths $\lambda$ of the light emitting element 13 and chromaticities Cx, concerning the phosphor 20 (red phosphor) in FIG. 9C.

The values of chromaticities Cx hold nearly constant value, even if wavelengths $\lambda$ (380nm to 400nm) of the light emitting element 13 vary concerning the fluorescent bodies 30, 40 as shown in FIGS. 9A, 9B.

However, the values of chromaticities Cx tend to decrease with increasing wavelength $\lambda$ (380nm to 400nm) of the light emitting element 13 concerning the phosphor 20 (red phosphor) as shown in FIG. 9C.

That is, the total weight of the phosphor 20, which has relatively-severer sensitivity dependence on the wavelength A of the light emitting element 13, is adjusted preferentially in the case where the wavelength A of the light emitting element 13 varies in the range of 380nm to 400nm. According to the method like this, the light emitting device 2, whose variation of chromaticities is suppressed certainly, is formed by correcting preferentially the density or the coating quantity of the phosphor 20, even if the wavelength A or the emission intensity P of the light emitting element 13 varies in every light emitting device.

(Third Embodiment)

An apparatus for manufacturing the light emitting device 3 which is possible to manufacture the light emitting devices 1, 2 is described below.

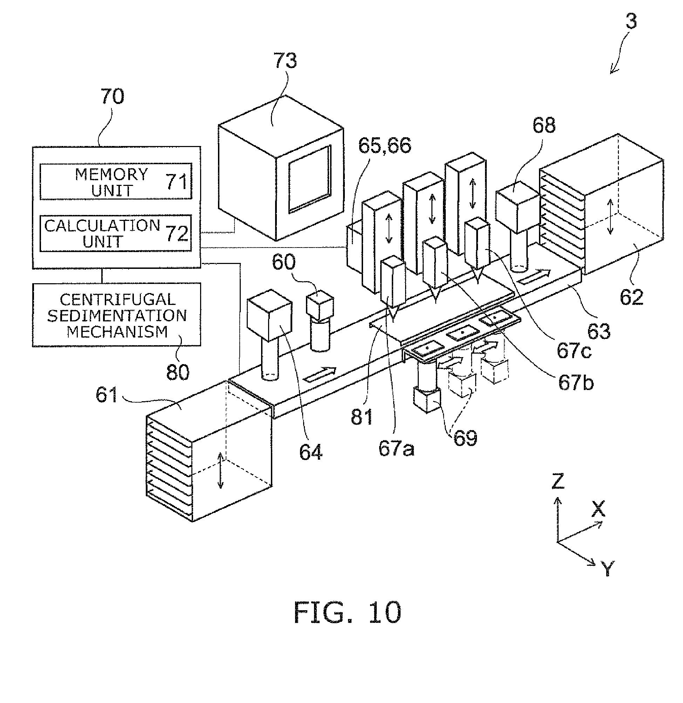

FIG. 10 is a schematic view of a principal part of an apparatus for manufacturing the light emitting device.

The apparatus 3 includes a loader 61 and an unloader 62. A transport mechanism 63 is provided between the loader 61 and the unloader 62. The package member 10, having the light emitting element 13 and so on, is put on a support stage 81 to be conveyed from the loader 61 to the transport mechanism 63. The conveyed package member 10 is processed in the manufacturing method described above, and stocked in an unloader 62. Accordingly, a first measurement unit 64 configured to measure the wavelength A or the emission intensity P of the light emitting element 13, the image recognition unit 60 (position detecting unit) configured to detect the position (3D-coordinate:X,Y,Z) of the light emitting element 13 with the image recognition, a position correcting unit 65 configured to correct the position of the light emitting element 13, a transfer mechanism 66 mounting the position correcting unit 65, a plurality of nozzles 67a, 67b, 67c (coating unit) being mounted on the transfer mechanism 66, and a second measurement unit 68 configured to measure an optical characteristics (chromaticities, wavelength, color rendering property, and so on) of the light emitting device are provided between the loader 61 and the unloader 62.

Each of different types of the phosphor is delivered from each of nozzles 67a, 67b, 67c. For instance, the resin member 21 containing the dispersed phosphor 20 is delivered from the nozzle 67a. The resin member 31 containing the dispersed phosphor 30 is delivered from the nozzle 67b. The resin member 41 containing the dispersed phosphor 40 is delivered from the nozzle 67c. The apparatus 3 further includes a maintenance unit 69 configured to detect a state before and after coating the phosphor.

A control unit 70 controls the image recognition unit 60, the loader 61, the unloader 62, the transport mechanism 63, the first measurement unit 64, the position correcting unit 65, the transfer mechanism 66, nozzles 67a, 67b, 67c, the second measurement unit 68, and the maintenance unit 69. For instance, once defects of the phosphor layers 22, 32, 42 are detected, the maintenance unit 69 sends the defects information to the control unit 70 to restore good coating conditions to normal by feedback control.

The control unit 70 includes a memory unit 71 configured to store the databases described above, and a calculation unit 72 configured to calculate the density and the coating quantity of the phosphor optimally by computing the data stored in the memory unit 71. Thus, the drop of the phosphor, having the optimum density and the optimum coating quantity, is put on the light emitting element 13 from each of nozzles 67a, 67b, 67c. The apparatus 3 for manufacturing the light emitting device further includes a monitor 73 configured to indicate measurement results, data, and calculating results, and a centrifugal sedimentation mechanism 80 configured to run centrifugal sedimentation described above. By the centrifugal sedimentation mechanism 80, a phosphor in any of the first phosphor layer, the second phosphor layer, and the third phosphor layer is made to be accumulated on a side of the light emitting element 13.

The method for manufacturing the light emitting devices 1, 2 is workable by using the apparatus 3.

And that is, the apparatus 3 includes a memorizing unit (e.g. the memory unit 71) configured to store a dependence property of chromaticities of the mixed light emitted from the light emitting element, the first phosphor, and the second phosphor on the wavelength and the emission intensity of the light emitting element, the first total weight of the first phosphor, or the second total weight of the second phosphor.

The apparatus 3 includes a measuring unit (e.g. the first measurement unit 64) configured to measure the wavelength and the emission intensity of the light emitting element.

The apparatus 3 includes a determining unit (e.g. the calculation unit 72) configured to determine the first total weight and the second total weight individually based on the dependence property so as to obtain predetermined chromaticities of the mixed light including the measured wavelength and emission intensity.

The apparatus 3 includes a covering unit (e.g. the nozzle 67a) configured to cover at least part of the light emitting element with the first phosphor layer containing the first phosphor of the first total weight.

The apparatus 3 includes a covering unit (e.g. the nozzle 67b) configured to cover at least part of the first phosphor layer with the second phosphor layer containing the second phosphor of the second total weight.

The apparatus 3 includes a memorizing unit (e.g. the memory unit 71) configured to store the dependence property of chromaticities of the mixed light emitted from the light emitting element, the first phosphor, the second phosphor, and the third phosphor on the wavelength and the emission intensity of the light emitting element 13, the first total weight of the first phosphor, the second total weight of the second phosphor, or the third total weight of the third phosphor.

The apparatus 3 includes a determining unit (e.g. the calculation unit 72) configured to determine the first total weight, the second total weight, and the third total weight individually based on the dependence property so as to obtain predetermined chromaticities of the mixed light including the measured wavelength and emission intensity.

The apparatus 3 includes a covering unit (e.g. the nozzle 67c) configured to cover at least part of the second phosphor layer with the third phosphor layer containing the third phosphor of the third total weight.

The phosphor layers 22, 32, 42 are formed by using the apparatus 3. Each of the phosphor layers 22, 32, 42 has the desired density, the desired coating quantity, and the desired position. Thus, the variation of chromaticities is suppressed in the light emitting device. The apparatus 3 can measure the spectrum of the light emitting device promptly. In the result, the apparatus 3 can correct the density, the coating quantity, and the position of the phosphor layer promptly, even if defect of the emission property occurs.

Hereinabove, embodiments are described with reference to specific examples. However, the embodiments are not limited to these specific examples. In other words, various modifications made by those skilled in the art to these specific examples as appropriate shall fall within the scope of the embodiment as long as they include the features of the embodiments. For instance, any component included in the above-described specific examples, as well as its arrangement, material, condition, shape, size and the like is not limited to what has been shown as its examples, and can be changed whenever deemed necessary.

In addition, the respective constituents included in the embodiments described above can be combined together within a technically achievable scope, and such a combination is also included in the scope of the embodiments as long as the combination includes the features of the embodiments.

Furthermore, those skilled in the art could conceive various modifications and alterations in the scope of the spirit of the embodiments. It shall be understood that such modifications and alterations pertain to the scope of the embodiments.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

**Claims**

1.   A light emitting device, comprising:

a package member (10);

a light emitting element (13) provided in the package member (10);

a first phosphor layer (22) provided on the light emitting element (13) and having a first phosphor (20); and

a second phosphor layer (32) provided above the first phosphor layer (22) and having a second phosphor (30), a luminescent efficiency of the first phosphor (20) being higher than a luminescent efficiency of the second phosphor (30).

2. The device according to claim 1, further comprising a third phosphor layer (42) provided on the light emitting element (13), the third phosphor layer (42) containing a third phosphor (40).

3. The device according to claim 2, wherein the luminescent efficiency of the first phosphor (20) is higher than the luminescent efficiency of the third phosphor (40).

4. A method for manufacturing a light emitting device including a package member (10), a light emitting element (13) provided in the package member (10), a first phosphor layer (22) provided on the slight emitting element (13) and having a first phosphor (20), and a second phosphor layer (32) provided on the first phosphor layer (22) and having a second phosphor (30), the method comprising:

determining previously a dependence property of chromaticities of a mixed light emitted from the light emitting element (13), the first phosphor (20), and the second phosphor (30) on a wavelength and an intensity of a light emitted from the light emitting element (13), a first total weight of the first phosphor (20), or a second total weight of the second phosphor (30);

measuring the wavelength and the intensity of the light emitted from the light emitting element (13);

determining the first total weight and the second total weight individually based on the dependence property so as to obtain predetermined chromaticities of the mixed light including the measured wavelength and the measured intensity;

covering at least a part of the light emitting element (13) with the first phosphor layer (22) containing the first phosphor (20) of the first total weight; and

covering at least a part of the first phosphor layer (22) with the second phosphor layer (32) containing the second phosphor (30) of the second total weight.

5. The method according to claim 4, wherein the wavelength of the light emitted from the light emitting element (13) is between not less than 440 nanometers and not more than 460 nanometers.

6. The method according to claim 4, further comprising:

forming a third phosphor layer (42) containing a third phosphor (40) on the second phosphor layer (32).

7. The method according to claim 6, wherein the dependence property of chromaticities of the mixed light emitted from the light emitting element (13), the first phosphor (20), the second phosphor (30) and the third phosphor (40) on the wavelength and the emission intensity of the light emitted from the light emitting element (13), the first total weight of the first phosphors (20), the second total weight of the second phosphor (30), or a third total weight of the third phosphor (40) is determined previously,

the first total weight, the second total weight, and the third total weight are determined individually based on the dependence property so as to obtain the predetermined chromaticities of the mixed light, and

at least a part of the second phosphor layer (32) is covered with the third phosphor layer (42) containing the third phosphor (40) of the third total weight.

8. The method according to claim 6 or 7, wherein the wavelength of the light emitted from the light emitting element (13) is between not less than 380 nanometers and not more than 400 nanometers.

9. The method according to any one of claim 6 to 8, wherein, when a sensitivity dependence on the wavelength of the light emitted from the light emitting element (13) varies among the first phosphor (20), the second phosphor (30), and the third phosphor (40), a total weight of a phosphor with the increasing sensitivity dependence is adjusted preferentially.

10. The method according to any one of claim 6 to 9, wherein a phosphor in at least one of the first phosphor layer (22), the second phosphor layer (32), and the third phosphor layer (42) is made to be accumulated on a side of the light emitting element (13) after forming any of the first phosphor layer (22), the second phosphor layer (32), and the third phosphor layer (42).

11. The method according to any one of claim 6 to 10, wherein a recess portion (10a) of the package member (10) is filled with a resin member (50) not containing any of the first phosphor (20), the second phosphor (30) and the third phosphor (40) before covering at least a part of the light emitting element (13) with the first phosphor layer (22).

12. The method according to claim 11, wherein a specific weight of a resin member (21) having the first phosphor (20) dispersed is lower than a specific weight of the resin member (50) not containing any of the first phosphor (20), the second phosphor (30) and the third phosphor (40).

13. The method according to any one of claim 4 to 12, wherein wavelengths and intensities of light in three colors are measured in the determining the dependence property.

14. The method according to claim 13, wherein the three colors are red, green, and blue.

15. An apparatus for manufacturing a light emitting device including a package member (10), a light emitting element (13) provided in the package member (10), a first phosphor layer (22) provided on the light emitting element (13) and having a first phosphor (20), and a second phosphor layer (32) provided on the first phosphor layer (22) and having a second phosphor (30), the apparatus comprising:

   a memorizing unit configured to store a dependence property of chromaticities of a mixed light emitted from the light emitting element (13), the first phosphor (20), and the second phosphor (30) on a wavelength and an intensity of a light emitted from the light emitting element (13), a first total weight of the first phosphor (20), or a second total weight of the second phosphor (30);
   a measuring unit configured to measure the wavelength and the intensity of the light emitted from the light emitting element (13);
   a determining unit configured to determine the first total weight and the second total weight individually based on the dependence property so as to obtain predetermined chromaticities of the mixed light including the measured wavelength and the measured intensity;
   a first covering unit configured to cover at least a part of the light emitting element (13) with a first phosphors layer (22) containing the first phosphor (20) of the first total weight; and
   a second covering unit configured to cover at least a part of the first phosphor layer (22) with a second phosphor layer (32) containing the second phosphor (30) of the second total weight.

16. The apparatus according to claim 15, further comprising:

   a third covering unit configured to cover a third phosphor layer (42) containing a third phosphor (40) on the second phosphor layer (32).

17. The apparatus according to claim 16, further comprising:

   a memorizing unit configured to store the dependence property of chromaticities of the mixed light emitted from the light emitting element (13), the first phosphor (20), the second phosphor (30), and the third phosphor (40) on the wavelength or the intensity of the light emitted from the light emitting element (13), the first total weight of the first phosphor (20), the second total weight of the second phosphor (30), or a third total weight of the third phosphor (40) previously;
   a determining unit configured to determine the first total weight, the second total weight, and the third total weight individually based on the dependence property so as to the obtain predetermined chromaticities of the mixed light.

FIG. 1A

FIG. 1B

FIG. 2A

FIG. 2B

```
┌─────────────────────────────┐
│   PREPARE PACKAGE MEMBER    │ ──── S10
│   INCLUDING LEAD FRAME      │
└─────────────────────────────┘
              │
              ▼
┌─────────────────────────────┐
│     MOUNT LIGHT EMITTING    │ ──── S20
│   ELEMENT ON LEAD FRAME     │
└─────────────────────────────┘
              │
              ▼
┌─────────────────────────────┐
│   MEASURE WAVELENGTH AND    │ ──── S30
│     INTENSITY OF LIGHT      │
│     EMITTED FROM LIGHT      │
│       EMITTING ELEMENT      │
└─────────────────────────────┘
              │
              ▼
┌─────────────────────────────┐
│     DETEMINE DESIRED        │ ──── S40
│   CHROMATICITIES Cx, Cy     │
└─────────────────────────────┘
              │
              ▼
┌─────────────────────────────┐
│       USE DATABASE          │ ──── S50
└─────────────────────────────┘
              │
              ▼
┌─────────────────────────────┐
│    DETERMINE TEMPORARY      │ ──── S60
│   CHROMATICITIES Cx', Cy'   │
└─────────────────────────────┘
              │
              ▼
┌─────────────────────────────┐
│  DETERMINE TOTAL WEIGHT OF  │ ──── S70
│   FLUORESCENT BODY IN FIRST │
│   AND SECOND FLUORESCENT    │
│        BODY LAYERS          │
└─────────────────────────────┘
              │
              ▼
┌─────────────────────────────┐
│  DETERMINE COATING DENSITY  │ ──── S80
│  AND QUANTITY OF FLUORESCENT│
│   BODY IN FIRST AND SECOND  │
│   FLUORESCENT BODY LAYERS   │
└─────────────────────────────┘
              │
              ▼
┌─────────────────────────────┐
│    FORM FIRST FLUORESCENT   │ ──── S90
│        BODY LAYER           │
└─────────────────────────────┘
              │
              ▼
┌─────────────────────────────┐
│   FORM SECOND FLUORESCENT   │ ──── S100
│        BODY LAYER           │
└─────────────────────────────┘
```

FIG. 3

FIG. 4A

FIG. 4B

FIG. 4C

FIG. 4D

FIG. 4E

FIG. 4F

FIG. 5A

FIG. 5B

FIG. 6A

FIG. 6B

FIG. 6C

**FIG. 7A**

**FIG. 7B**

FIG. 8A

FIG. 8B

FIG. 8C

FIG. 8D

FIG. 8E

FIG. 8F

FIG. 8G

FIG. 8H

FIG. 9A

FIG. 9B

FIG. 9C

3

73

70

65,66

68

MEMORY
UNIT 71

CALCULATION
UNIT 72

60

62

CENTRIFUGAL
SEDIMENTATION
MECHANISM

63

80

67c

61

67b

64

81    67a

69

67a

Z

X

Y

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009147312 A